(19) Europäisches Patentamt / European Patent Office / Office européen des brevets

(11) **EP 4 692 825 A1**

(12) **EUROPEAN PATENT APPLICATION**
published in accordance with Art. 153(4) EPC

(43) Date of publication:
**11.02.2026 Bulletin 2026/07**

(21) Application number: **24803660.0**

(22) Date of filing: **03.05.2024**

(51) International Patent Classification (IPC):
**G01R 31/396** (2019.01)   **G01R 31/08** (2020.01)
**G01R 19/10** (2006.01)   **G01R 19/30** (2006.01)
**H02J 7/00** (2026.01)   **B60R 16/033** (2006.01)
**B60L 58/10** (2019.01)

(52) Cooperative Patent Classification (CPC):
Y02E 60/10

(86) International application number:
**PCT/KR2024/005995**

(87) International publication number:
**WO 2024/232606 (14.11.2024 Gazette 2024/46)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **11.05.2023 KR 20230061140**

(71) Applicant: **LG Energy Solution, Ltd.**
**Seoul 07335 (KR)**

(72) Inventor: **CHOI, Jung Hwan**
**Daejeon 34122 (KR)**

(74) Representative: **Plasseraud IP**
**104 Rue de Richelieu**
**CS92104**
**75080 Paris Cedex 02 (FR)**

(54) **BATTERY MANAGEMENT DEVICE AND OPERATION METHOD THEREOF**

(57)  A battery management apparatus according to an embodiment disclosed herein includes a data management unit configured to calculate an open circuit voltage (OCV) of each of a plurality of batteries and a controller configured to calculate an average OCV of the plurality of batteries and calculate a diagnosis deviation that is a deviation between the OCV and the average OCV for each of the plurality of batteries, classify the diagnosis deviation of each of the plurality of batteries according to a range of the average OCV to generate a diagnosis deviation for each range of the average OCV, and diagnose at least one of the plurality of batteries based on the diagnosis deviation for each range of the average OCV of each of the plurality of batteries.

200

DATA MANAGEMENT UNIT
210
—
CONTROLLER
220

FIG.2

**Description**

**[TECHNICAL FIELD]**

CROSS-REFERENCE TO RELATED APPLICATION

This application claims priority to and the benefit of Korean Patent Application No. 10-2023-0061140 filed in the Korean Intellectual Property Office on May 11, 2023, the entire content of which is incorporated herein by reference.

TECHNICAL FIELD

Embodiments disclosed herein relate to a battery management apparatus and an operating method thereof.

**[BACKGROUND ART]**

An electric vehicle is supplied with electricity from outside to charge a battery cell, and then a motor is driven by a voltage charged in the battery cell to obtain power. The battery cell of the electric vehicle is manufactured by receiving an electrode assembly in a battery case and injecting an electrolyte into the battery case.

In production of battery cells, an abnormal battery cell may be produced which includes an under-voltage defect where the voltage of the battery cell is reduced to a predetermined level or lower for reasons such as a foreign substance, folding of a separator, inner short, etc., or an under-capacity defect where the capacity of the battery cell is less than that of a normal battery cell. The abnormal battery cell may be difficult to diagnose because of a difficulty in separately measuring an abnormal voltage behavior of the abnormal battery cell due to a voltage change caused by the use of the abnormal battery cell in a vehicle after the abnormal battery cell is mounted on the vehicle.

**[DISCLOSURE]**

**[TECHNICAL PROBLEM]**

Embodiments disclosed herein aim to provide a battery management apparatus and an operating method thereof in which an abnormal battery cell may be early diagnosed by using a deviation of an open circuit voltage (OCV) of a battery cell, thereby securing safety and reliability of battery energy.

Technical problems of the embodiments disclosed herein are not limited to the above-described technical problems, and other unmentioned technical problems would be clearly understood by one of ordinary skill in the art from the following description.

**[TECHNICAL SOLUTION]**

A battery management apparatus according to an embodiment disclosed herein includes a data management unit configured to calculate an open circuit voltage (OCV) of each of a plurality of batteries and a controller configured to calculate an average OCV of the plurality of batteries and calculate a diagnosis deviation that is a deviation between the OCV and the average OCV for each of the plurality of batteries, classify the diagnosis deviation of each of the plurality of batteries according to a range of the average OCV to generate a diagnosis deviation for each range of the average OCV, and diagnose at least one of the plurality of batteries based on the diagnosis deviation for each range of the average OCV of each of the plurality of batteries.

According to an embodiment, the controller may be further configured to calculate a mean value or a median value of OCVs of the plurality of batteries as the average OCV and classify the diagnosis deviation of each of the plurality of batteries into a first diagnosis deviation, a second diagnosis deviation, and a third diagnosis deviation in a descending order of the range of the average OCV.

According to an embodiment, the controller may be further configured to diagnose at least one of the plurality of batteries based on whether the first diagnosis deviation and the third diagnosis deviation of each of the plurality of batteries fall within a first threshold range.

According to an embodiment, the controller may be further configured to, when a first diagnosis deviation and a third diagnosis deviation of the at least one of the plurality of batteries fall out of the first threshold range, diagnose the battery as an under-voltage battery.

According to an embodiment, the controller may be further configured to, when a first diagnosis deviation and a third diagnosis deviation of the at least one of the plurality of batteries fall within the first threshold range and the first diagnosis deviation and the third diagnosis deviation of the battery fall out of a second threshold range, diagnose the battery based on an accumulative balancing time of the battery.

According to an embodiment, the controller may be further configured to calculate an accumulative balancing time of each of the plurality of batteries, calculate a reference time based on a mean value or a median value of accumulative balancing times of the plurality of batteries, and diagnose the battery based on whether the accumulative balancing time of the battery is less than the reference time.

According to an embodiment, the controller may be further configured to, when the first diagnosis deviation and the third diagnosis deviation of the at least one of the plurality of batteries fall within the first threshold range and out of the second threshold range, diagnose the battery as the under-voltage battery.

According to an embodiment, the controller may be further configured to calculate a fourth diagnosis deviation which is a difference between an average of the first diagnosis deviation of each of the plurality of batteries and an average of the third diagnosis deviation and diagnose at least one of the plurality of batteries based on whether a fourth diagnosis deviation of each of the plurality of batteries falls within a third threshold range.

According to an embodiment, the controller may be further configured to, when the fourth diagnosis deviation of the at least one of the plurality of batteries falls out of the third threshold range, diagnose the battery as an under-capacity battery.

An operating method of a battery management apparatus according to an embodiment disclosed herein includes calculating an open circuit voltage (OCV) of each of a plurality of batteries, calculating an average OCV of the plurality of batteries, calculating a diagnosis deviation that is a deviation between the OCV and the average OCV for each of the plurality of batteries, classifying the diagnosis deviation of each of the plurality of batteries according to a range of the average OCV to generate a diagnosis deviation for each range of the average OCV, and diagnosing at least one of the plurality of batteries based on the diagnosis deviation for each range of the average OCV of each of the plurality of batteries.

According to an embodiment, the calculating of the average OCV of the plurality of batteries may include calculating a mean value or a median value of OCVs of the plurality of batteries as the average OCV, and the classifying of the diagnosis deviation of each of the plurality of batteries according to a range of the average OCV to generate the diagnosis deviation for each range of the average OCV may include classifying the diagnosis deviation of each of the plurality of batteries into a first diagnosis deviation, a second diagnosis deviation, and a third diagnosis deviation in a descending order of the range of the average OCV.

According to an embodiment, the diagnosing of the at least one of the plurality of batteries based on the diagnosis deviation for each range of the average OCV of each of the plurality of batteries may include diagnosing at least one of the plurality of batteries based on whether the first diagnosis deviation and the third diagnosis deviation of each of the plurality of batteries fall within a first threshold range.

According to an embodiment, the diagnosing of the at least one of the plurality of batteries based on the diagnosis deviation for each range of the average OCV of each of the plurality of batteries may include, when a first diagnosis deviation and a third diagnosis deviation of the at least one of the plurality of batteries fall out of the first threshold range, diagnosing the battery as an under-voltage battery.

According to an embodiment, the diagnosing of the at least one of the plurality of batteries based on the diagnosis deviation for each range of the average OCV of each of the plurality of batteries may include, when a first diagnosis deviation and a third diagnosis deviation of the at least one of the plurality of batteries fall within the first threshold range and the first diagnosis deviation and the third diagnosis deviation of the battery fall out of a second threshold range, diagnosing the battery based on an accumulative balancing time of the battery.

According to an embodiment, the diagnosing of the at least one of the plurality of batteries based on the diagnosis deviation for each range of the average OCV of each of the plurality of batteries may include calculating an accumulative balancing time of each of the plurality of batteries, calculating a reference time based on a mean value or a median value of accumulative balancing times of the plurality of batteries, and diagnosing the battery based on whether the accumulative balancing time of the battery is less than the reference time.

According to an embodiment, the diagnosing of the at least one of the plurality of batteries based on the diagnosis deviation for each range of the average OCV of each of the plurality of batteries may include, when the first diagnosis deviation and the third diagnosis deviation of the at least one of the plurality of batteries fall within the first threshold range and out of the second threshold range, and the accumulative balancing time of the battery is less than the reference time, diagnosing the battery as the under-voltage battery.

According to an embodiment, the diagnosing of the at least one of the plurality of batteries based on the diagnosis deviation for each range of the average OCV of each of the plurality of batteries may include calculating a fourth diagnosis deviation which is a difference between an average of the first diagnosis deviation of each of the plurality of batteries and an average of the third diagnosis deviation and diagnosing at least one of the plurality of batteries based on whether a fourth diagnosis deviation of each of the plurality of batteries falls within a third threshold range.

According to an embodiment, the diagnosing of the at least one of the plurality of batteries based on the diagnosis deviation for each range of the average OCV of each of the plurality of batteries may include, when the fourth diagnosis deviation of the at least one of the plurality of batteries falls out of the third threshold range, diagnosing the battery as an under-capacity battery.

**[ADVANTAGEOUS EFFECTS]**

With the battery management apparatus and the operating method thereof according to an embodiment disclosed herein, an abnormal battery cell may be early diagnosed by using a deviation of an OCV of a battery cell, thereby securing safety and reliability of battery energy.

**[DESCRIPTION OF DRAWINGS]**

FIG. 1 illustrates a battery pack according to an embodiment disclosed herein.
FIG. 2 is a block diagram illustrating a configuration of a battery management apparatus, according to an embodiment disclosed herein.
FIG. 3 is a graph showing a change in voltage of a battery cell according to an embodiment disclosed herein.
FIG. 4 is a graph showing a change in open circuit voltage (OCV) of a battery cell according to an embodiment disclosed herein.
FIG. 5 is a graph showing a change in diagnosis deviation of a battery cell according to an embodiment disclosed herein.
FIG. 6A is a graph showing a change in first diagnosis deviation of a battery cell according to an embodiment disclosed herein.
FIG. 6B is a graph showing a change in third diagnosis deviation of a battery cell according to an embodiment disclosed herein.
FIG. 7 is a graph showing a cumulative balancing time of a battery cell according to an embodiment disclosed herein.
FIG. 8A is a graph showing a change in first diagnosis deviation of a battery cell according to another embodiment disclosed herein.
FIG. 8B is a graph showing a change in third diagnosis deviation of a battery cell according to another embodiment disclosed herein.
FIG. 9A is a graph showing a change in first diagnosis deviation of a battery cell according to another embodiment disclosed herein.
FIG. 9B is a graph showing a change in third diagnosis deviation of a battery cell according to another embodiment disclosed herein.
FIG. 10 is a graph showing a fourth diagnosis deviation of a battery cell according to an embodiment disclosed herein.
FIG. 11 is a flowchart showing an operating method of a battery management apparatus, according to an embodiment disclosed herein.
FIG. 12 is a flowchart illustrating a method of diagnosing an under-voltage battery cell, according to an embodiment disclosed herein.
FIG. 13 is a flowchart illustrating a method of diagnosing an under-capacity battery cell, according to an embodiment disclosed herein.
FIG. 14 is a block diagram showing a hardware configuration of a computing system for performing an operating method of a battery management apparatus, according to an embodiment disclosed herein.

**[MODE FOR INVENTION]**

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.
To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

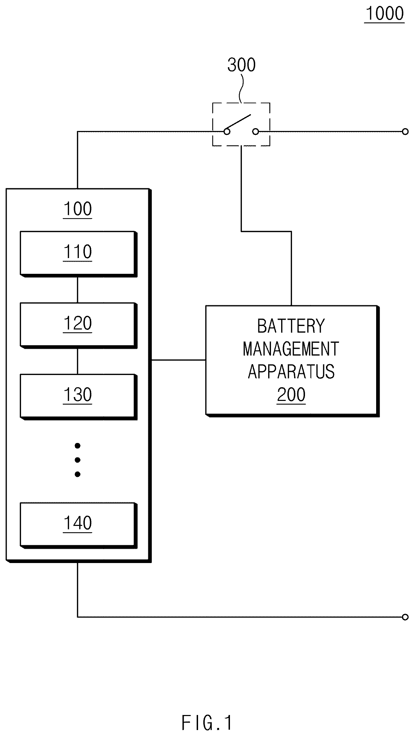

FIG. 1 illustrates a battery pack according to an embodiment disclosed herein.

Referring to FIG. 1, a battery pack 1000 according to an embodiment disclosed herein may include a battery module 100, a battery management apparatus 200, and a relay 300. According to various embodiments, the battery module 100 may be a battery cell, and in this case, the battery pack 1000 may have a cell-to-pack structure.

While it is shown in FIG. 1 that the battery module 100 is one, the present disclosure is not limited thereto such that the battery pack 1000 may include a plurality of battery modules that form a stacked structure. The battery module 100 may include a plurality of battery cells 110, 120, 130, and 140. Although the plurality of battery cells are illustrated as four in FIG. 1, the present disclosure is not limited thereto, and the battery module 100 may include n battery cells (n is a natural number equal to or greater than 2).

The battery module 100 may supply power to a target device (not shown). To this end, the battery module 100 may be electrically connected to the target device. Herein, the target device may include an electrical, electronic, or mechanical device that operates by receiving power from the battery pack 1000 including the plurality of battery cells 110, 120, 130, and 140, and the target device may be, for example, an electric vehicle (EV) or an energy storage system (ESS), but is not limited thereto.

The plurality of battery cells 110, 120, 130, and 140, each of which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery module 100 is illustrated in FIG. 1, the battery module 100 may be configured in plural according to an embodiment.

The battery management apparatus 200 may manage and/or control a state and/or an operation of the battery module 100. For example, the battery management apparatus 200 may manage and/or control the states and/or operations of the plurality of battery cells 110, 120, 130, and 140 included in the battery module 100. The battery management apparatus 200 may manage charging and/or discharging of the battery module 100.

The battery management apparatus 200 may control an operation of the relay 300. For example, the battery management apparatus 200 may short-circuit the relay 300 to supply power to the target device. The battery management apparatus 200 may short-circuit the relay 300 when a charging device is connected to the battery pack 1000. In addition, the battery management apparatus 200 may monitor a voltage, a current, a temperature, etc., of the battery module 100 and/or each of the plurality of battery cells 110, 120, 130, and 140 included in the battery module 100. A sensor or various measurement modules for monitoring performed by the battery management apparatus 200, which are not shown, may be additionally installed in the battery module 100, a charging/discharging path, any position of the battery module 100, etc. The battery management apparatus 200 may calculate a parameter indicating a state of the battery module 100, e.g., a state of charge (SOC), based on a measurement value such as monitored voltage, current, temperature, etc.

The battery management apparatus 200 may include a balancing circuit (not shown). Herein, the balancing circuit may mean a circuit including a resistor and a switching element connected to both ends of each of the plurality of battery cells 110, 120, 130, and 140. The battery management apparatus 200 may transmit a control signal to the balancing circuit to turn ON/OFF the switching element. The battery management apparatus 200 may control connection of the resistor through ON/OFF of the switching element of the balancing circuit to consume a balancing current of the battery cell, thus to lower a voltage, thereby adjusting a voltage of each battery cell to be the same as each other.

More specifically, when voltage deviations, i.e., SOC deviations, among the plurality of battery cells 110, 120, 130, and 140 are greater than or equal to a specific level, the battery management apparatus 200 may balance the voltages of the plurality of battery cells 110, 120, 130, and 140 using the balancing circuit. For example, the battery management apparatus 200 may balance a battery cell corresponding to a maximum voltage when a difference between the maximum voltage and a minimum voltage among the voltages of the plurality of battery cells 110, 120, 130, and 140 is greater than or equal to a preset threshold level. The battery management apparatus 200 may set a target voltage of the battery cell for balancing the battery cell and transmit a control signal to the balancing circuit to terminate balancing when the voltage of the battery cell reaches the target voltage.

The battery management apparatus 200 may calculate a balancing time of each of the plurality of battery cells 110, 120, 130, and 140. Herein, the balancing time may be defined as a time required for balancing of the battery cell. For example, the battery management apparatus 200 may calculate a balancing time based on an SOC, a battery capacity, and a balancing efficiency of each of the plurality of battery cells 110, 120, 130, and 140.

The battery management apparatus 200 may analyze an open circuit voltage (OCV) of a battery cell. Herein, the OCV may mean a voltage measured when the current of the battery does not flow. That is, the OCV may be a voltage between both electrodes in a state where a fuel electrode (anode) and an air electrode (cathode) of the battery are not electrically connected to each other. According to the Ohm's law, as the battery's resistance increases infinitely, the current may approach '0', thereby accurately measuring the voltage of the battery. Thus, the battery management apparatus 200 may measure and analyze the OCV of the battery cell for accurate electrochemical analysis of the battery cell.

According to an embodiment, the battery management apparatus 200 may diagnose whether at least one battery cell among the plurality of battery cells 110, 120, 130, and 140 is an under-voltage battery cell by using a deviation dV of the OCV of each of the plurality of battery cells 110, 120, 130, and 140 and an accumulative balancing time of each of the plurality of battery cells 110, 120, 130, and 140. For an under-voltage battery cell, SOC deviations may occur with a normal battery cell due to a self-discharge phenomenon over time. Thus, a battery pack including an under-voltage battery cell may perform balancing on battery cells by using a balancing circuit for addressing SOC deviations among the battery cells, increasing a cumulative balancing time for the battery pack. In this case, the balancing circuit may perform balancing on a battery cell having the highest SOC rather than a battery cell having the lowest SOC, such that a balancing time of the under-voltage battery cell included in the battery pack is recorded as being shorter than those of other normal battery cells. Thus, the battery management apparatus 200 may diagnose an under-voltage battery cell by using deviations of OCVs and balancing times of the plurality of battery cells 110, 120, 130, and 140.

According to an embodiment, the battery management apparatus 200 may diagnose, among the plurality of battery cells 110, 120, 130, and 140, an under-capacity battery cell including a battery cell having short-circuit in an electrode tab thereof or having both the short-circuit in the electrode tab and lithium precipitation, by using the deviations dV of the OCVs of the plurality of battery cells 110, 120, 130, and 140. Herein, lithium precipitation refers to a phenomenon in which lithium ions from a positive electrode during charging of a battery cell fail to be chemically coupled to a negative electrode and exist in the form of metal on a surface of the negative electrode. For a normal battery cell, lithium ions from a positive electrode of the battery cell are reduced into a negative electrode, but for an under-capacity battery cell, some lithium ions may precipitate in the form of lithium metal on a surface of the negative electrode. When lithium precipitation repetitively occurs and thus a lithium byproduct grows, contact of the lithium byproduct with a positive electrode or a positive electrode collector may cause inner short between a negative electrode and the positive electrode of the battery cell. A battery cell in which the inner short occurs may have an OCV deviation with a normal battery cell due to self-discharge over time. Thus, the battery management apparatus 200 may diagnose an under-capacity battery cell by using the deviations of the OCVs of the plurality of battery cells 110, 120, 130, and 140.

The following operation of the battery management apparatus 200 may also be performed in the battery management apparatus 200 or various devices such as a server, a cloud, a charger, a charger/discharger, etc., connected to a vehicle having the battery management apparatus 200 mounted thereon.

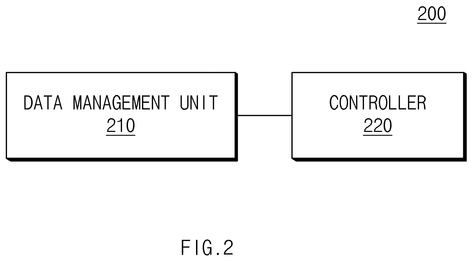

FIG. 2 is a view for describing in detail a configuration of a battery management apparatus according to an embodiment disclosed herein.

Hereinbelow, a configuration of the battery management apparatus 200 will be described in detail with reference to FIG. 2.

Referring to FIG. 2, the battery management apparatus 200 may include a data management unit 210 and a controller 220.

The data management unit 210 may calculate a voltage of each of the plurality of battery cells 110, 120, 130, and 140. The data management unit 210 may calculate the voltage of each of the plurality of battery cells 110, 120, 130, and 140 for each unit time to calculate time-series data of the voltage of each of the plurality of battery cells 110, 120, 130, and 140.

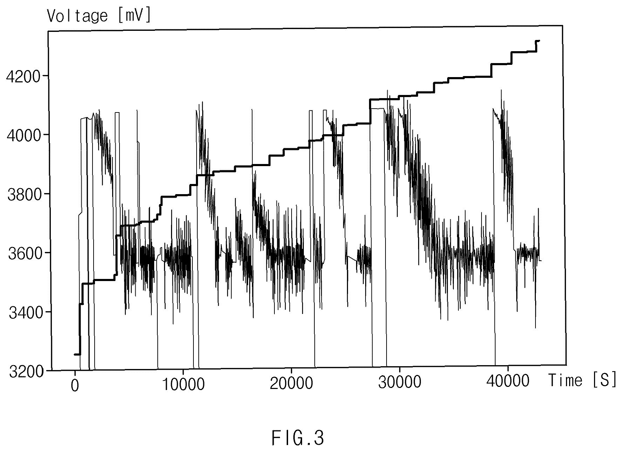

FIG. 3 is a graph showing a change in voltage of a battery cell according to an embodiment disclosed herein.

Referring to FIG. 3, the data management unit 210 may continuously calculate voltage rise and drop and long-term relaxation data of the plurality of battery cells 110, 120, 130, and 140 in charging, a rest period after charging, discharging, and a rest period after discharging.

According to an embodiment, the data management unit 210 may calculate time-series data of a voltage of each of the plurality of battery cells 110, 120, 130, and 140 for each battery module. For example, when the battery pack 1000 includes a total of 8 battery modules, each of which includes 16 battery cells, then the data management unit 210 may calculate time-series data of voltages of the 16 battery cells for each battery module.

The data management unit 210 may calculate an OCV of each of the plurality of battery cells 110, 120, 130, and 140, which is a voltage measured when a current of a battery cell approaches '0' from voltage data of each of the plurality of battery cells 110, 120, 130, and 140. The data management unit 210 may calculate the OCV of each of the plurality of battery cells 110, 120, 130, and 140 for accurate electrochemical analysis of each of the plurality of battery cells 110, 120, 130, and 140.

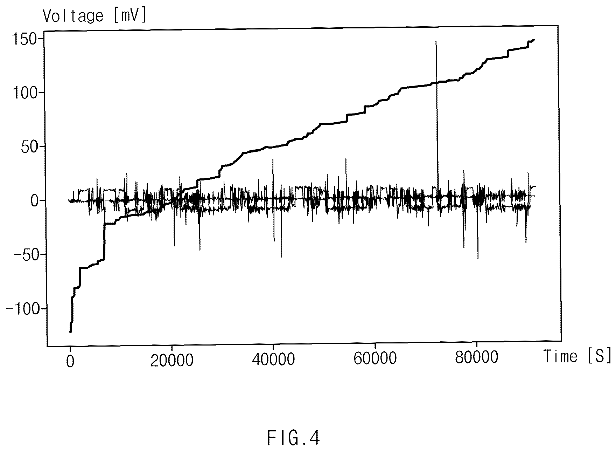

FIG. 4 is a graph showing a change in OCV of a battery cell according to an embodiment disclosed herein.

Referring to FIG. 4, the data management unit 210 may calculate time-series data of the OCV of each of the plurality of battery cells 110, 120, 130, and 140 by continuously calculating the OCV of each of the plurality of battery cells 110, 120, 130, and 140.

According to an embodiment, the data management unit 210 may calculate the time-series data of the OCV of each of the plurality of battery cells 110, 120, 130, and 140 for each battery module.

According to an embodiment, the controller 220 may diagnose whether at least one battery cell among the plurality of battery cells 110, 120, 130, and 140 is an under-voltage battery cell by using the deviation dV of the OCV of each of the plurality of battery cells 110, 120, 130, and 140 and an accumulative balancing time of each of the plurality of battery cells 110, 120, 130, and 140.

First, the controller 220 may calculate an average OCV V_avg of the plurality of battery cells 110, 120, 130, and 140. For example, the controller 220 may calculate a mean value Mean, a median value Median, or a minimum value Min of the OCVs of the plurality of battery cells 110, 120, 130, and 140 as the average OCV V_avg of the plurality of battery cells 110, 120, 130, and 140.

According to an embodiment, the controller 220 may calculate the average OCV V_avg of the plurality of battery cells 110, 120, 130, and 140 for each battery module. For example, when the battery pack 1000 includes a total of 8 battery modules, each of which includes 16 battery cells, then the controller 220 may calculate the average OCV V_avg, which is an average of OCVs of the 16 battery cells for each battery module.

The controller 220 may calculate the deviation dV between the OCV and the average OCV V_avg for each of the plurality of battery cells 110, 120, 130, and 140.

Specifically, the controller 220 may calculate a diagnosis deviation dV of each of the plurality of battery cells 110, 120, 130, and 140, based on Equation 1.

Diagnosis Deviation (dV) = Open Circuit Voltage (OCV) - Average Open Circuit Voltage (V_avg)         [Equation 1]

Referring to Equation 1, the controller 220 may calculate, as the diagnosis deviation dV, the deviation between the OCV and the average OCV V_avg for each of the plurality of battery cells 110, 120, 130, and 140.

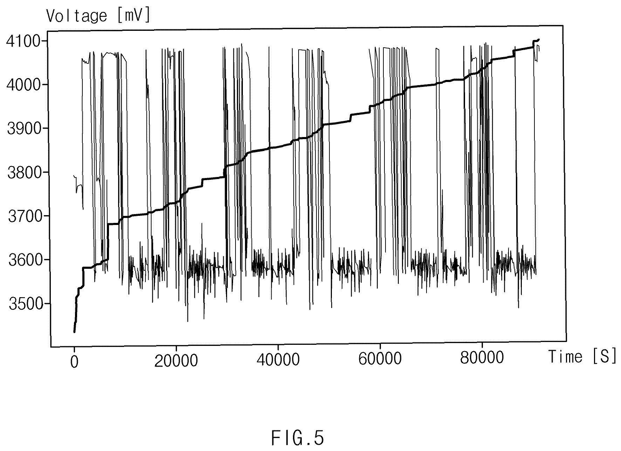

FIG. 5 is a graph showing a change in diagnosis deviation of a battery cell according to an embodiment disclosed herein.

Referring to FIG. 5, the controller 220 may calculate a deviation between the OCV and the average OCV V_avg for each of the plurality of battery cells 110, 120, 130, and 140 for each battery module. For example, when the battery pack 1000 includes a total of 8 battery modules, each of which includes 16 battery cells, then the controller 220 may calculate the average OCV V_avg, which is an average of OCVs of the 16 battery cells for each battery module, and calculate the diagnosis deviation dV which is a deviation between the average OCV V_avg and the OCV of each battery cell, for each battery module. Battery cells included in the same battery module may have a battery module-based tendency in which characteristics, such as a scale error, an off-set error, noise, etc., are the same as one another. Thus, to normalize different characteristics for different battery modules, the controller 220 may calculate the diagnosis deviation dV which is a deviation between the average OCV V_avg of battery cells included in a battery module and an OCV of each battery cell.

The controller 220 may calculate time-series data of the diagnosis deviation dV of each of the plurality of battery cells 110, 120, 130, and 140 by calculating the diagnosis deviation dV of each of the plurality of battery cells 110, 120, 130, and 140 for each unit time.

The controller 220 may classify the diagnosis deviation dV of each of the plurality of battery cells 110, 120, 130, and 140 according to a range of the average OCV V_avg of the plurality of battery cells 110, 120, 130, and 140. For example, the controller 220 may classify the diagnosis deviation dV of each of the plurality of battery cells 110, 120, 130, and 140 included in each battery module according to the range of the average OCV V_avg for each battery module.

Specifically, the controller 220 may classify the diagnosis deviation dV of each of the plurality of battery cells 110, 120, 130, and 140 according to the range of the average OCV V_avg of the plurality of battery cells 110, 120, 130, and 140 or a range of an SOC of the battery pack 1000 including the plurality of battery cells 110, 120, 130, and 140.

The controller 220 may classify the range of the average OCV V_avg of the plurality of battery cells 110, 120, 130, and 140 into a first section, a second section, and a third section in a descending order of the average OCV V_avg or the SOC of the battery pack 1000. For example, the first section may be defined as a section in which the average OCV V_avg of the plurality of battery cells 110, 120, 130, and 140 is about 3500 mv or the SOC of the battery pack 1000 is 20 % to 30 %. For example, the second section may be defined as a section in which the average OCV V_avg of the plurality of battery cells 110, 120, 130, and 140 is about 3800 mv or the SOC of the battery pack 1000 is 45% to 55 %. For example, the third section may be defined as a section in which the average OCV V_avg of the plurality of battery cells 110, 120, 130, and 140 is about 4100 mv or the SOC of the battery pack 1000 is 85% to 99 %.

The controller 220 may classify the diagnosis deviation dV of each of the plurality of battery cells 110, 120, 130, and 140 into a first diagnosis deviation dV1, a second diagnosis deviation dV2, and a third diagnosis deviation dV3 according to the range of the average OCV V_avg. Specifically, the controller 220 may classify the diagnosis deviation dV of each of the plurality of battery cells 110, 120, 130, and 140 as the first diagnosis deviation dV1 when the range of the average OCV V_avg of the plurality of battery cells 110, 120, 130, and 140 corresponds to the first section. The controller 220 may also classify the diagnosis deviation dV of each of the plurality of battery cells 110, 120, 130, and 140 as the second diagnosis deviation dV2 when the range of the average OCV V_avg of the plurality of battery cells 110, 120, 130, and 140 corresponds to the second section. The controller 220 may also classify the diagnosis deviation dV of each of the plurality of battery cells 110, 120, 130, and 140 as the third diagnosis deviation dV3 when the range of the average OCV V_avg of the plurality of battery cells 110, 120, 130, and 140 corresponds to the third section.

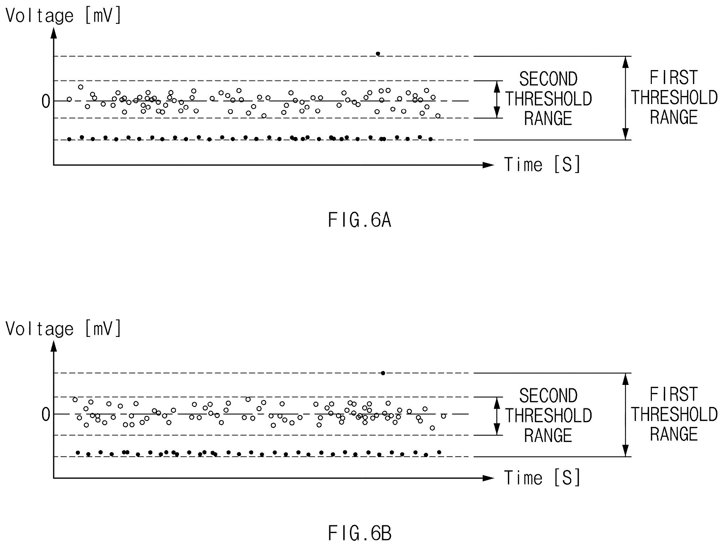

FIG. 6A is a graph showing a change in first diagnosis deviation of a battery cell according to an embodiment disclosed herein. FIG. 6B is a graph showing a change in third diagnosis deviation of a battery cell according to an embodiment disclosed herein.

Referring to FIGS. 6A and 6B, the controller 220 may calculate time-series data of the first diagnosis deviation dV1 and time-series data of the third diagnosis deviation dV3 for each of the plurality of battery cells 110, 120, 130, and 140. The controller 220 may diagnose at least one of the plurality of battery cells 110, 120, 130, and 140, based on the time-series data of the first diagnosis deviation dV1 and the time-series data of the third diagnosis deviation dV3 for each of the plurality of battery cells 110, 120, 130, and 140.

Specifically, the controller 220 may analyze the time-series data of the first diagnosis deviation dV1 and the time-series data of the third diagnosis deviation dV3 for each of the plurality of battery cells 110, 120, 130, and 140 and, when the time-series data of the first diagnosis deviation dV1 of at least one of the plurality of battery cells 110, 120, 130, and 140 continuously falls out of a threshold range and at the same time, the time-series data of the third diagnosis deviation dV3 of the corresponding battery cell continuously falls out of the threshold range, the controller 220 may diagnose the corresponding battery cell as an under-voltage battery cell.

The controller 220 may diagnose at least one of the plurality of battery cells 110, 120, 130, and 140, based on whether the time-series data of the first diagnosis deviation dV1 and the time-series data of the third diagnosis deviation dV3 for each of the plurality of battery cells 110, 120, 130, and 140 fall within a first threshold range. Specifically, when the first diagnosis deviation dV1 of at least one of the plurality of battery cells 110, 120, 130, and 140 falls out of the first threshold range and the third diagnosis deviation dV3 of the corresponding battery cell falls out of the first threshold range, the controller 220 may diagnose the battery cell as an under-voltage battery cell. Herein, the first threshold range may be a criterion for determining the battery cell as the under-voltage battery cell. That is, the first threshold range may be a criterion indicating how much the first diagnostic deviation dV1 of the corresponding battery cell is different from the deviation of the OCV of a normal battery cell. For example, the first threshold range may be from (-)20 mV to (+) 20 mV.

When the first diagnosis deviation dV1 and the third diagnosis deviation dV3 of at least one of the plurality of battery cells 110, 120, 130, and 140 fall within the first threshold range and out of a second threshold range, the controller 220 may determine, based on the accumulative balancing time of the corresponding battery cell, whether the corresponding battery cell is an under-voltage battery cell. Herein, the second threshold range may be a range of a threshold voltage that may be corrected by the balancing circuit of the battery management apparatus 200 through a balancing operation.

Specifically, when the first diagnosis deviation dV1 and the third diagnosis deviation dV3 of at least one of the plurality of battery cells 110, 120, 130, and 140 do not exceed the first threshold range that is a reference range for determining an under-voltage battery cell, but fall out of the second threshold range, the controller 220 may determine, based on the accumulative balancing time of the corresponding battery cell, whether the corresponding battery cell is an under-voltage battery cell.

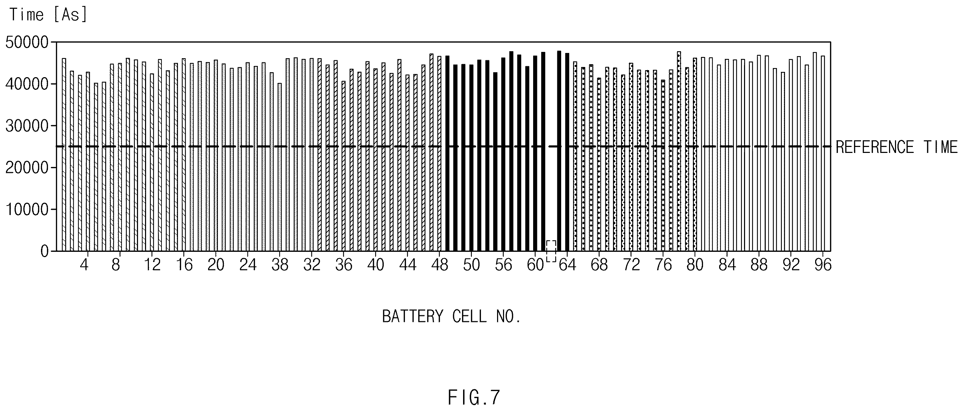

FIG. 7 is a graph showing a cumulative balancing time of a battery cell according to an embodiment disclosed herein.

Referring to FIG. 7, the controller 220 may diagnose at least one battery cell among the plurality of battery cells 110, 120, 130, and 140, by comparing the accumulative balancing time of each of the plurality of battery cells 110, 120, 130, and 140 with a reference time.

The controller 220 may calculate the balancing time of each of the plurality of battery cells 110, 120, 130, and 140, based on an SOC, a battery capacity, and a balancing efficiency of each of the plurality of battery cells 110, 120, 130, and 140. For example, the controller 220 may calculate the balancing time of each of the plurality of battery cells 110, 120, 130, and 140 by measuring a time for which balancing is performed for each battery cell as the switching element of the balancing circuit connected to each of the battery cells 110, 120, 130, and 140 is turned ON.

The controller 220 may record a balancing time of each of the plurality of battery cells 110, 120, 130, and 140 in the memory (not provided) at preset intervals. For example, the controller 220 may separately store the balancing time of each of the plurality of battery cells 110, 120, 130, and 140 or separately store a balancing time per battery module 100 including the plurality of battery cells 110, 120, 130, and 140.

The controller 220 may accumulate and record a balancing time of each of the plurality of battery cells 110, 120, 130, and 140 in the memory. That is, the controller 220 may calculate a cumulative balancing time of each of the plurality of battery cells 110, 120, 130, and 140.

According to an embodiment, the controller 220 may separately store a cumulative balancing time for each of the plurality of battery cells 110, 120, 130, and 140 based on a battery cell number of each of the plurality of battery cells 110, 120, 130, and 140. According to an embodiment, the controller 220 may separately manage a cumulative balancing time per battery module based on a battery module number of the battery module 100 including each of the plurality of battery cells 110, 120, 130, and 140. For example, when the battery pack 1000 includes a total of 8 battery modules, each of which includes 16 battery cells, then the data management unit 210 may separately manage cumulative balancing times of 128 battery cells based on a battery cell number of each of the 128 battery cells and a battery module number of a battery module including each battery cell.

The controller 220 may list the plurality of battery cells 110, 120, 130, and 140 based on their cumulative balancing times and extract a battery cell within a threshold rank from among the plurality of battery cells 110, 120, 130, and 140. For example, the controller 220 may list the plurality of battery cells 110, 120, 130, and 140 based on their cumulative balancing times and extract the plurality of other battery cells 110, 120, 130, and 140 than the plurality of battery cells 110, 120, 130, and 140 corresponding to top 10 % and bottom 10%.

The controller 220 may calculate a mean value Mean or a median value Median of the accumulative balancing times of the plurality of battery cells 110, 120, 130, and 140 as an average balancing time of the plurality of battery cells 110, 120, 130, and 140. The controller 220 may calculate the reference time based on the average balancing time of the plurality of battery cells 110, 120, 130, and 140. Herein, the reference time may be a criterion for diagnosing a battery cell as an under-voltage battery cell. That is, the reference time may be a criterion indicating how much the balancing time of the battery cell is different from a balancing time of a normal battery cell.

The controller 220 may generate the reference time based on Equation 2 below.

$$\text{Reference Time} = \text{Average Balancing Time} - \text{Standard Deviation } (\sigma) \times \text{Threshold Constant} \qquad \text{[Equation 2]}$$

Referring to Equation 2, the controller 220 may calculate the standard deviation $\sigma$ of the accumulative balancing time of each of the plurality of battery cells 110, 120, 130, and 140. According to an embodiment, the controller 220 may calculate the standard deviation $\sigma$ of the accumulative balancing time of each battery cell within a threshold rank. For example, the controller 220 may list the plurality of battery cells 110, 120, 130, and 140 based on their cumulative balancing times and calculate the standard deviation $\sigma$ of the accumulative balancing times of the plurality of other battery cells 110, 120, 130, and 140 than the plurality of battery cells 110, 120, 130, and 140 corresponding to top 10 % and bottom 10%.

The controller 220 may calculate the reference time by subtracting a product of the standard deviation $\sigma$ and the threshold constant from the average balancing time of the plurality of battery cells 110, 120, 130, and 140.

When the first diagnosis deviation dV1 and the third diagnosis deviation dV3 of at least one of the plurality of battery cells 110, 120, 130, and 140 fall within the first threshold range and out of the second threshold range, the controller 220 may diagnose the corresponding battery cell as an under-voltage battery cell based on whether the accumulative balancing time of the battery cell is less than the reference time. Specifically, when the first diagnosis deviation dV1 and the third diagnosis deviation dV3 of at least one of the plurality of battery cells 110, 120, 130, and 140 fall within the first threshold range and out of the second threshold range and the accumulative balancing time of the corresponding battery cell is less than the reference time, the controller 220 may diagnose the corresponding battery cell as an under-voltage battery cell.

According to an embodiment, the controller 220 may diagnose whether at least any one of the plurality of battery cells 110, 120, 130, and 140 is an under-capacity battery cell, based on the first diagnosis deviation dV1 and the third diagnosis deviation dV3 of each of the plurality of battery cells 110, 120, 130, and 140. A battery cell may have a disconnection at a positive or negative tab due to various reasons such as defects at the production stage, internal deformation and denaturation through multiple a plurality of charging and discharging, external shock, etc. In this case, when lithium precipitation and electrode tab disconnection occur together in the battery cell, the electrode of the disconnected battery cell and the electrode of the normal battery cell may be connected to each other by a lithium precipitate. Herein, when the negative electrode of the disconnected battery cell has a higher SOC than the negative electrode of the normal battery, the negative electrodes of the two battery cells contact with each other by the lithium precipitate such that charging may occur from the negative electrode of the disconnected battery cell to the negative electrode of the normal battery. Thus, the under-capacity battery cell having lithium precipitation and disconnection in the electrode tab together may undergo faster voltage change than the normal battery cell.

Thus, the controller 220 may compare OCV data of a battery cell with statistical normal OCV data of a normal battery cell to diagnose an under-capacity battery cell having electrode tab disconnection and lithium precipitation, by using a phenomenon in which the under-capacity battery cell having electrode tab disconnection and lithium precipitation occurring together has a faster and larger voltage change than the normal battery cell.

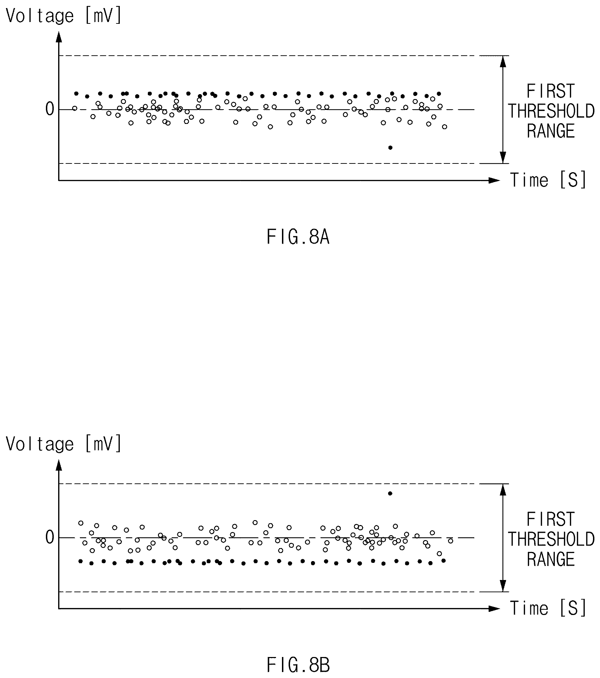

FIG. 8A is a graph showing a change in first diagnosis deviation of a battery cell according to another embodiment disclosed herein. FIG. 8B is a graph showing a change in third diagnosis deviation of a battery cell according to another embodiment disclosed herein.

Referring to FIG. 8A, the controller 220 may calculate time-series data of the first diagnosis deviation dV1 of each of the plurality of battery cells 110, 120, 130, and 140 by calculating the first diagnosis deviation dV1 of each of the plurality of battery cells 110, 120, 130, and 140 for each unit time.

Referring to FIG. 8B, the controller 220 may calculate time-series data of the third diagnosis deviation dV3 of each of the plurality of battery cells 110, 120, 130, and 140 by calculating the third diagnosis deviation dV1 of each of the plurality of battery cells 110, 120, 130, and 140 for each unit time.

The controller 220 may calculate a mean value Mean of the first diagnosis deviation dV1 of each of the plurality of battery cells 110, 120, 130, and 140 for a unit time or a median value Median of the first diagnosis deviation dV1 for the unit time. The controller 220 may calculate, as an average dV1_avg of the first diagnosis deviation dV1, the mean value or the median value of the first diagnosis deviation dV1 of each of the plurality of battery cells 110, 120, 130, and 140 for the unit time.

The controller 220 may calculate the mean value or median value of the third diagnosis deviation dV3 of each of the plurality of battery cells 110, 120, 130, and 140 for the unit time. The controller 220 may calculate, as an average dV3_avg of the third diagnosis deviation dV3, the mean value or the median value of the third diagnosis deviation dV3 of each of the plurality of battery cells 110, 120, 130, and 140 for the unit time.

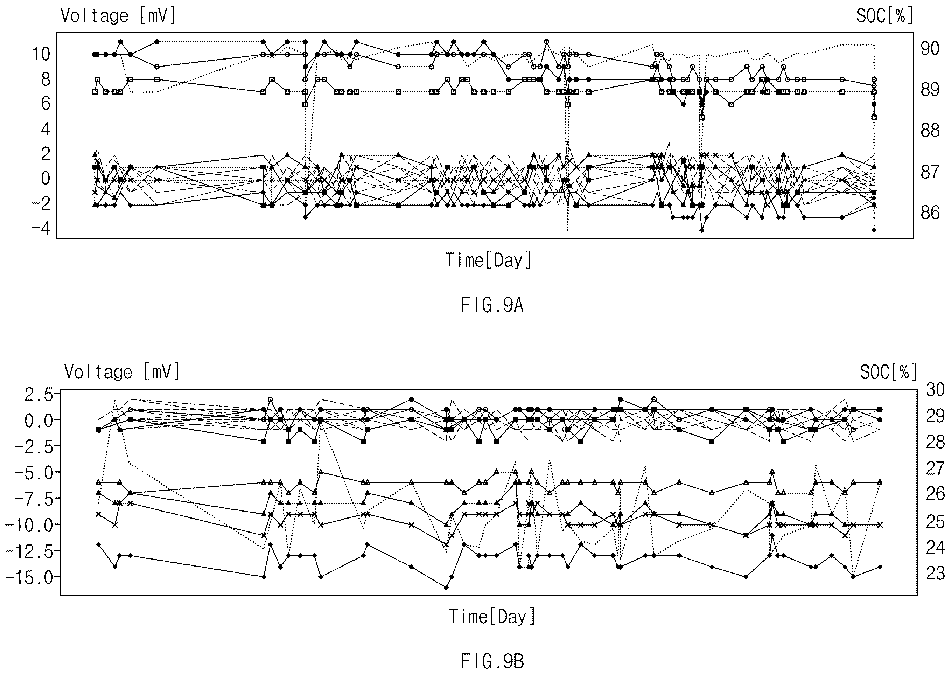

FIG. 9A is a graph showing a change in first diagnosis deviation of a battery cell according to another embodiment disclosed herein. FIG. 9B is a graph showing a change in third diagnosis deviation of a battery cell according to another embodiment disclosed herein.

Referring to FIG. 9A, the controller 220 may calculate time-series data of the first diagnosis deviation dV1 of each of the plurality of battery cells 110, 120, 130, and 140.

Referring to FIG. 9B, the controller 220 may calculate time-series data of the third diagnosis deviation dV3 of each of the plurality of battery cells 110, 120, 130, and 140.

The controller 220 may diagnose the under-capacity battery cell by calculating a difference between the time-series data of the first diagnosis deviation and the time-series data of the third diagnosis deviation for each of the plurality of battery cells 110, 120, 130, and 140. Specifically, the controller 220 may calculate a difference between the average dV1_avg of the first diagnosis deviation of each of the plurality of battery cells 110, 120, 130, and 140 corresponding to the first section in which the range of the average OCV V_avg of the plurality of battery cells 110, 120, 130, and 140 is relatively low and the average dV3_avg of the third diagnosis deviation of each of the plurality of battery cells 110, 120, 130, and 140 corresponding to the third section in which the range of the average OCV V_avg is relatively high, thereby diagnosing the under-capacity battery cell having a faster and larger OCV change than the normal battery cell.

Specifically, the controller 220 may calculate, as the fourth diagnosis deviation dV4 of each of the plurality of battery cells 110, 120, 130, and 140, a difference between the average dV1_avg of the first diagnosis deviation and the average dV3_avg of the third diagnosis deviation for each of the plurality of battery cells 110, 120, 130, and 140.

The controller 220 may calculate the fourth diagnosis deviation dV4 of each of the plurality of battery cells 110, 120, 130, and 140, based on Equation 3.

Fourth Diagnosis Deviation (dV4) = Average (dV1_avg) of First Diagnosis Deviation - Average (dV3_avg) of Third Diagnosis Deviation [Equation 3]

Specifically, the controller 220 may calculate, as the fourth diagnosis deviation dV4 of each of the plurality of battery cells 110, 120, 130, and 140, a deviation between the average dV1_avg of the first diagnosis deviation and the average dV3_avg of the third diagnosis deviation for each of the plurality of battery cells 110, 120, 130, and 140. The controller 220 may diagnose whether at least any one of the plurality of battery cells 110, 120, 130, and 140 is the under-capacity battery cell, by using the fourth diagnosis deviation dV4 of each of the plurality of battery cells 110, 120, 130, and 140.

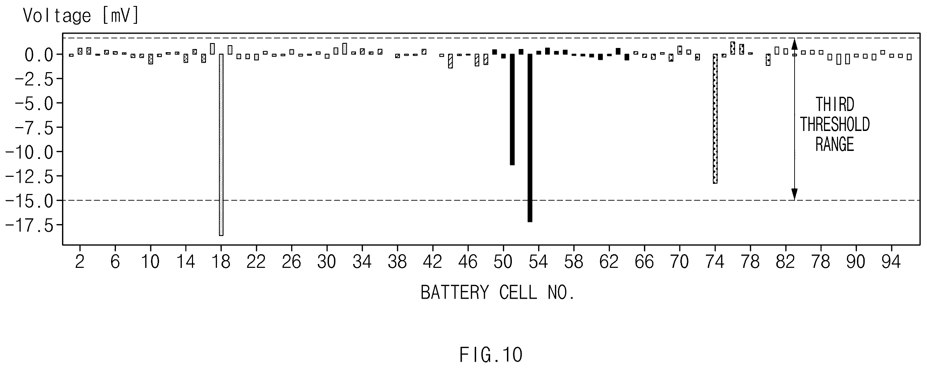

FIG. 10 is a graph showing a fourth diagnosis deviation of a battery cell according to an embodiment disclosed herein.

Referring to FIG. 10, when the fourth diagnosis deviation dV4 of at least any one of the plurality of battery cells 110, 120, 130, and 140 falls out of a third threshold range, the controller 220 may diagnose the corresponding battery cell as the under-capacity battery cell. Herein, the third threshold range may be a criterion for determining the battery cell as the under-capacity battery cell. For example, the third threshold range may be from (-)15 mV to (+) 5 mV.

When the controller 220 determines that the under-voltage battery cell or the under-capacity battery cell occurs in the battery cell, as a result of diagnosis, the controller 220 may provide information about the corresponding battery cell to a user. For example, the controller 220 may provide information about the under-voltage battery cell or the under-capacity battery cell to a user terminal through a communication unit (not shown) and provide the information about the battery cell through a display provided in a vehicle, a charger, etc.

As described above, with the battery management apparatus according to an embodiment disclosed herein, an abnormal battery cell may be early diagnosed by using a deviation of an OCV of a battery cell, thereby securing safety and reliability of battery energy.

In addition, the battery management apparatus 200 may not need separation of the battery cell because of diagnosing the abnormal battery cell using the OCV deviations of the battery cells in a state of the battery cells mounted on the vehicle, thereby rapidly and conveniently diagnosing the abnormal battery cell.

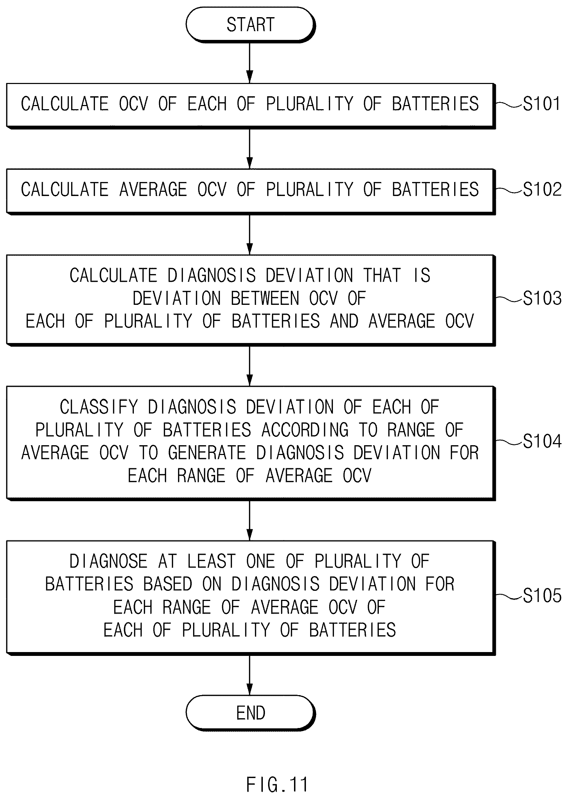

FIG. 11 is a flowchart showing an operating method of a battery management apparatus, according to an embodiment disclosed herein.

Hereinbelow, an operating method of the battery management apparatus 200 will be described with reference to FIGS. 1 and 10.

The battery management apparatus 200 may be substantially the same as the battery management apparatus 200 described with reference to FIGS. 1 to 10, and thus will be briefly described to avoid redundant description.

Referring to FIG. 11, the operating method of the battery management apparatus may include operation S101 of calculating an OCV of each of a plurality of batteries, operation S102 of calculating an average OCV of the plurality of batteries, operation S103 of calculating a diagnosis deviation that is a deviation between the OCV and the average OCV for each of the plurality of batteries, operation S104 of classifying the diagnosis deviation of each of the plurality of batteries according to a range of the average OCV to generate a diagnosis deviation for each range of the average OCV, and operation S105 of diagnosing at least one of the plurality of batteries based on the diagnosis deviation for each range of the average OCV of each of the plurality of batteries.

Hereinbelow, operations S101 through S105 will be described in detail.

In operation S101, the data management unit 210 may calculate the voltage of each of the plurality of battery cells 110, 120, 130, and 140. The data management unit 210 may calculate the voltage of each of the plurality of battery cells 110, 120, 130, and 140 for each unit time to calculate time-series data of the voltage of each of the plurality of battery cells 110, 120, 130, and 140.

In operation S101, the data management unit 210 may continuously calculate voltage rise and drop and long-term relaxation data of the plurality of battery cells 110, 120, 130, and 140 in charging, a rest period after charging, discharging, and a rest period after discharging.

In operation S101, according to an embodiment, the data management unit 210 may calculate time-series data of a voltage of each of the plurality of battery cells 110, 120, 130, and 140 for each battery module. For example, when the battery pack 1000 includes a total of 8 battery modules, each of which includes 16 battery cells, then the data management unit 210 may calculate time-series data of voltages of the 16 battery cells for each battery module.

In operation S101, the data management unit 210 may calculate the OCV of each of the plurality of battery cells 110, 120, 130, and 140, which is a voltage measured when a current of a battery cell approaches '0' from voltage data of each of the plurality of battery cells 110, 120, 130, and 140.

In operation S101, the data management unit 210 may calculate time-series data of the OCV of each of the plurality of battery cells 110, 120, 130, and 140 by continuously calculating the OCV of each of the plurality of battery cells 110, 120, 130, and 140.

In operation S101, according to an embodiment, the data management unit 210 may calculate the time-series data of the OCV of each of the plurality of battery cells 110, 120, 130, and 140 for each battery module.

In operation S102, the controller 220 may calculate the average OCV V_avg of the plurality of battery cells 110, 120, 130, and 140. For example, the controller 220 may calculate a mean value Mean, a median value Median, or a minimum value Min of the OCVs of the plurality of battery cells 110, 120, 130, and 140 as the average OCV V_avg of the plurality of battery cells 110, 120, 130, and 140.

In operation S102, the controller 220 may calculate the average OCV V_avg of the plurality of battery cells 110, 120, 130, and 140 for each battery module. For example, when the battery pack 1000 includes a total of 8 battery modules, each of which includes 16 battery cells, then the controller 220 may calculate the average OCV V_avg, which is an average of OCVs of the 16 battery cells for each battery module.

In operation S103, the controller 220 may calculate the deviation dV between the OCV and the average OCV V_avg for each of the plurality of battery cells 110, 120, 130, and 140.

In operation S103, specifically, the controller 220 may calculate a diagnosis deviation dV of each of the plurality of battery cells 110, 120, 130, and 140, based on Equation 4.

Diagnosis Deviation (dV) = Open Circuit Voltage (OCV) - Average Open Circuit Voltage (V_avg)          [Equation 4]

Referring to Equation 4, the controller 220 may calculate, as the diagnosis deviation dV, the deviation dV between the OCV and the average OCV V_avg for each of the plurality of battery cells 110, 120, 130, and 140.

In operation S103, the controller 220 may calculate a deviation between the OCV and the average OCV V_avg for each of the plurality of battery cells 110, 120, 130, and 140 for each battery module. For example, when the battery pack 1000 includes a total of 8 battery modules, each of which includes 16 battery cells, then the controller 220 may calculate the average OCV V_avg, which is an average of OCVs of the 16 battery cells for each battery module, and calculate the diagnosis deviation dV which is a deviation between the average OCV V_avg and the OCV of each battery cell, for each battery module.

In operation S103, the controller 220 may calculate time-series data of the diagnosis deviation dV of each of the plurality of battery cells 110, 120, 130, and 140 by calculating the diagnosis deviation dV of each of the plurality of battery cells 110, 120, 130, and 140 for each unit time.

In operation S104, the controller 220 may classify the diagnosis deviation dV of each of the plurality of battery cells 110, 120, 130, and 140 according to a range of the average OCV V_avg of the plurality of battery cells 110, 120, 130, and 140. For example, the controller 220 may classify the diagnosis deviation dV of each of the plurality of battery cells 110, 120, 130, and 140 included in each battery module according to the range of the average OCV V_avg for each battery module.

In operation S104, specifically, the controller 220 may classify the diagnosis deviation dV of each of the plurality of battery cells 110, 120, 130, and 140 according to the range of the average OCV V_avg of the plurality of battery cells 110, 120, 130, and 140 or a range of an SOC of the battery pack 1000 including the plurality of battery cells 110, 120, 130, and 140.

In operation S104, the controller 220 may classify the range of the average OCV V_avg of the plurality of battery cells 110, 120, 130, and 140 into a first section, a second section, and a third section in a descending order of the average OCV V_avg or the SOC of the battery pack 1000. For example, the first section may be defined as a section in which the average OCV V_avg of the plurality of battery cells 110, 120, 130, and 140 is about 3500 mv or the SOC of the battery pack 1000 is 20 % to 30 %. For example, the second section may be defined as a section in which the average OCV V_avg of the plurality of battery cells 110, 120, 130, and 140 is about 3800 mv or the SOC of the battery pack 1000 is 45% to 55%. For example, the third section may be defined as a section in which the average OCV V_avg of the plurality of battery cells 110, 120, 130, and 140 is about 4100 mv or the SOC of the battery pack 1000 is 85% to 99%.

In operation S104, the controller 220 may classify the diagnosis deviation dV of each of the plurality of battery cells 110, 120, 130, and 140 into a first diagnosis deviation dV1, a second diagnosis deviation dV2, and a third diagnosis deviation dV3 according to the range of the average OCV V_avg. Specifically, the controller 220 may classify the diagnosis deviation dV of each of the plurality of battery cells 110, 120, 130, and 140 as the first diagnosis deviation dV1 when the range of the average OCV V_avg of the plurality of battery cells 110, 120, 130, and 140 corresponds to the first section. The controller 220 may also classify the diagnosis deviation dV of each of the plurality of battery cells 110, 120, 130, and 140 as the second diagnosis deviation dV2 when the range of the average OCV V_avg of the plurality of battery cells 110, 120, 130, and 140 corresponds to the second section. The controller 220 may also classify the diagnosis deviation dV of each of the plurality of battery cells 110, 120, 130, and 140 as the third diagnosis deviation dV3 when the range of the average OCV V_avg of the plurality of battery cells 110, 120, 130, and 140 corresponds to the third section.

In operation S105, the controller 220 may calculate the time-series data of the first diagnosis deviation dV1 and the time-series data of the third diagnosis deviation dV3 for each of the plurality of battery cells 110, 120, 130, and 140. In operation S104, the controller 220 may diagnose at least one of the plurality of battery cells 110, 120, 130, and 140, based on the time-series data of the first diagnosis deviation dV1 and the time-series data of the third diagnosis deviation dV3 for each of the plurality of battery cells 110, 120, 130, and 140.

In operation S105, the controller 220 may analyze the time-series data of the first diagnosis deviation dV1 and the time-series data of the third diagnosis deviation dV3 for each of the plurality of battery cells 110, 120, 130, and 140 and, when the time-series data of the first diagnosis deviation dV1 of at least one of the plurality of battery cells 110, 120, 130, and 140 continuously falls out of a threshold range and at the same time, the time-series data of the third diagnosis deviation dV3 of the corresponding battery cell continuously falls out of the threshold range, the controller 220 may diagnose the corresponding battery cell as an under-voltage battery cell.

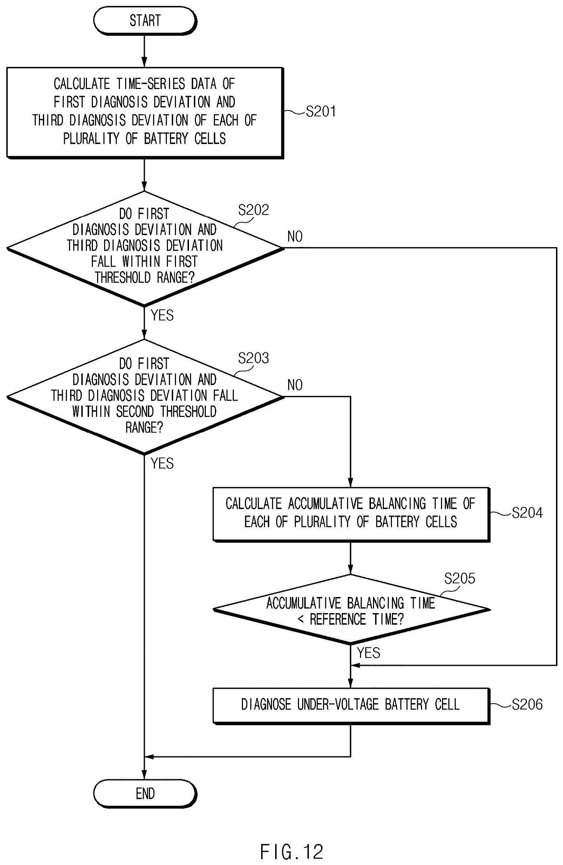

FIG. 12 is a flowchart illustrating a method of diagnosing an under-voltage battery cell, according to an embodiment disclosed herein.

Hereinbelow, referring to FIG. 12, a detailed description will be made of a method, performed by the controller 220, of diagnosing at least one of the plurality of battery cells 110, 120, 130, and 140 based on whether the time-series data of the first diagnosis deviation dV1 and the time-series data of the third diagnosis deviation dV3 for each of the plurality of battery cells 110, 120, 130, and 140 fall within the first threshold range.

In operation S201, the controller 220 may calculate the time-series data of the first diagnosis deviation dV1 and the time-series data of the third diagnosis deviation dV3 for each of the plurality of battery cells 110, 120, 130, and 140.

In operation S202, the controller 220 may determine whether the first diagnosis deviation dV1 and the third diagnosis deviation dV3 for each of the plurality of battery cells 110, 120, 130, and 140 fall within the first threshold range. Herein, the first threshold range may be a criterion for determining the battery cell as the under-voltage battery cell. That is, the first threshold range may be a criterion indicating how much the first diagnostic deviation dV1 of the corresponding battery cell is different from the deviation of the OCV of a normal battery cell. For example, the first threshold range may be from (-)20 mV to (+) 20 mV.

In operation S203, the controller 220 may determine whether the first diagnosis deviation dV1 and the third diagnosis deviation dV3 for each of the plurality of battery cells 110, 120, 130, and 140 fall within the second threshold range. Herein, the second threshold range may be a range of a threshold voltage that may be corrected by the balancing circuit of the battery management apparatus 200 through a balancing operation.

In operation S204, when the first diagnosis deviation dV1 and the third diagnosis deviation dV3 of at least one of the plurality of battery cells 110, 120, 130, and 140 fall within the first threshold range and out of the second threshold range, the controller 220 may calculate an accumulative balancing time of the corresponding battery cell. In operation S204, specifically, when the first diagnosis deviation dV1 and the third diagnosis deviation dV3 of at least one of the plurality of battery cells 110, 120, 130, and 140 do not exceed the first threshold range that is a reference range for determining an under-voltage battery cell, but fall out of the second threshold range, the controller 220 may calculate the accumulative balancing time of the corresponding battery cell.

In operation S204, the controller 220 may calculate the balancing time of each of the plurality of battery cells 110, 120, 130, and 140, based on an SOC, a battery capacity, and a balancing efficiency of each of the plurality of battery cells 110, 120, 130, and 140. For example, the controller 220 may calculate the balancing time of each of the plurality of battery cells 110, 120, 130, and 140 by measuring a time for which balancing is performed for each battery cell as the switching element of the balancing circuit connected to each of the battery cells 110, 120, 130, and 140 is turned ON.

In operation S204, the controller 220 may record a balancing time of each of the plurality of battery cells 110, 120, 130, and 140 in the memory (not provided) at preset intervals. For example, the controller 220 may separately store the balancing time of each of the plurality of battery cells 110, 120, 130, and 140 or separately store a balancing time per battery module 100 including the plurality of battery cells 110, 120, 130, and 140.

In operation S204, the controller 220 may accumulate and record a balancing time of each of the plurality of battery cells 110, 120, 130, and 140 in the memory. That is, the controller 220 may calculate a cumulative balancing time of each of the plurality of battery cells 110, 120, 130, and 140.

In operation S204, according to an embodiment, the controller 220 may separately store a cumulative balancing time for each of the plurality of battery cells 110, 120, 130, and 140 based on a battery cell number of each of the plurality of battery cells 110, 120, 130, and 140. According to an embodiment, the controller 220 may separately manage a cumulative balancing time per battery module based on a battery module number of the battery module 100 including each of the plurality of battery cells 110, 120, 130, and 140.

In operation S204, the controller 220 may calculate a mean value Mean or a median value Median of the accumulative balancing times of the plurality of battery cells 110, 120, 130, and 140 as an average balancing time of the plurality of battery cells 110, 120, 130, and 140.

In operation S205, the controller 220 may calculate the reference time based on the average balancing time of the plurality of battery cells 110, 120, 130, and 140. Herein, the reference time may be a criterion for diagnosing a battery cell as an under-voltage battery cell. That is, the reference time may be a criterion indicating how much the balancing time of the battery cell is different from a balancing time of a normal battery cell.

In operation S205, the controller 220 may generate the reference time based on Equation 5 below.

$$\text{Reference Time} = \text{Average Balancing Time} - \text{Standard Deviation } (\sigma) \times \text{Threshold Constant} \qquad \text{[Equation 5]}$$

In operation S205, referring to Equation 5, the controller 220 may calculate the standard deviation $\sigma$ of the accumulative balancing time of each of the plurality of battery cells 110, 120, 130, and 140. According to an embodiment, the controller 220 may calculate the standard deviation $\sigma$ of the accumulative balancing time of each battery cell within a threshold rank. For example, the controller 220 may list the plurality of battery cells 110, 120, 130, and 140 based on their cumulative balancing times and calculate the standard deviation $\sigma$ of the accumulative balancing times of the plurality of other battery cells 110, 120, 130, and 140 than the plurality of battery cells 110, 120, 130, and 140 corresponding to top 10% and bottom 10%.

In operation S205, the controller 220 may calculate the reference time by subtracting a product of the standard deviation $\sigma$ and the threshold constant from the average balancing time of the plurality of battery cells 110, 120, 130, and 140.

In operation S206, according to an embodiment, when the first diagnosis deviation dV1 and the third diagnosis deviation dV3 of at least one of the plurality of battery cells 110, 120, 130, and 140 fall out of the first threshold range, the controller 220 may diagnose the corresponding battery cell as the under-voltage battery cell.

In operation S206, according to an embodiment, when the first diagnosis deviation dV1 and the third diagnosis deviation dV3 of at least one of the plurality of battery cells 110, 120, 130, and 140 fall within the first threshold range and out of the second threshold range, the controller 220 may diagnose the corresponding battery cell as an under-voltage battery cell based on whether the accumulative balancing time of the battery cell is less than the reference time. In operation S206, specifically, when the first diagnosis deviation dV1 and the third diagnosis deviation dV3 of at least one of the plurality of battery cells 110, 120, 130, and 140 fall out of the first threshold range and the second threshold range and the accumulative balancing time of the corresponding battery cell is less than the reference time, the controller 220 may diagnose the corresponding battery cell as an under-voltage battery cell.

In operation S206, when the controller 220 determines that the under-voltage battery cell occurs in a battery cell, as a result of diagnosis, the controller 220 may provide information about the battery cell to a user. For example, the controller 220 may provide information about the under-voltage battery cell to a user terminal through a communication unit (not shown) and provide the information about the corresponding battery cell through a display provided in a vehicle, a charger, etc.

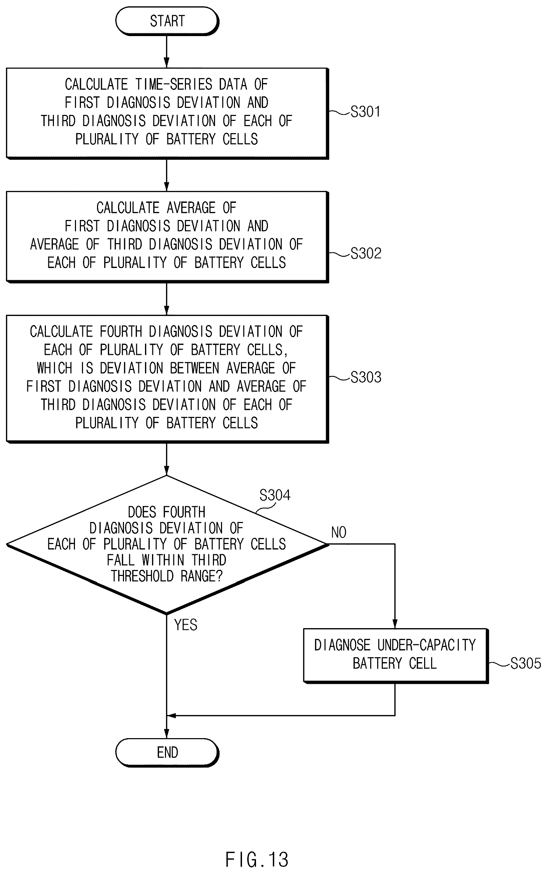

FIG. 13 is a flowchart illustrating a method of diagnosing an under-capacity battery cell, according to an embodiment disclosed herein.

Hereinbelow, a detailed description will be made of a method, performed by the controller 220, of diagnosing whether at least any one of the plurality of battery cells 110, 120, 130, and 140 is an under-capacity battery cell, based on the first diagnosis deviation dV1 and the third diagnosis deviation dV3 of each of the plurality of battery cells 110, 120, 130, and 140. The controller 220 may compare OCV data of a battery cell with statistical normal OCV data of a normal battery cell to diagnose an under-capacity battery cell having electrode tab disconnection and lithium precipitation, by using a phenomenon in which the under-capacity battery cell having electrode tab disconnection and lithium precipitation occurring together has a faster and larger voltage change than the normal battery cell.

In operation S301, the controller 220 may calculate the time-series data of the first diagnosis deviation dV1 and the time-series data of the third diagnosis deviation dV3 for each of the plurality of battery cells 110, 120, 130, and 140.

In operation S301, the controller 220 may calculate time-series data of the first diagnosis deviation dV1 of each of the plurality of battery cells 110, 120, 130, and 140 by calculating the first diagnosis deviation dV1 of each of the plurality of battery cells 110, 120, 130, and 140 for each unit time.

In operation S301, the controller 220 may calculate time-series data of the third diagnosis deviation dV3 of each of the plurality of battery cells 110, 120, 130, and 140 by calculating the third diagnosis deviation dV1 of each of the plurality of battery cells 110, 120, 130, and 140 for each unit time.

In operation S302, the controller 220 may calculate a mean value Mean or a median value Median of the first diagnosis deviation dV1 of each of the plurality of battery cells 110, 120, 130, and 140 for a unit time. In operation S302, the controller 220 may calculate, as the average dV1_avg of the first diagnosis deviation dV1, the mean value or the median value of the first diagnosis deviation dV1 of each of the plurality of battery cells 110, 120, 130, and 140 for the unit time.

In operation S302, the controller 220 may calculate the mean value or median value of the third diagnosis deviation dV3 of each of the plurality of battery cells 110, 120, 130, and 140 for the unit time. In operation S302, the controller 220 may calculate, as the average dV3_avg of the third diagnosis deviation dV3, the mean value or the median value of the third diagnosis deviation dV3 of each of the plurality of battery cells 110, 120, 130, and 140 for the unit time.

In operation S303, the controller 220 may calculate a difference between the average dV1_avg of the first diagnosis deviation and the average dV3_avg of the third diagnosis deviation for each of the plurality of battery cells 110, 120, 130, and 140. In operation S303, specifically, the controller 220 may calculate the difference between the average dV1_avg of the first diagnosis deviation of each of the plurality of battery cells 110, 120, 130, and 140 corresponding to the first section in which the range of the average OCV V_avg of the plurality of battery cells 110, 120, 130, and 140 is relatively low and the average dV3_avg of the third diagnosis deviation of each of the plurality of battery cells 110, 120, 130, and 140 corresponding to the third section in which the range of the average OCV V_avg is relatively high.

In operation S303, specifically, the controller 220 may calculate, as the fourth diagnosis deviation dV4 of each of the plurality of battery cells 110, 120, 130, and 140, a deviation between the average dV1_avg of the first diagnosis deviation and the average dV3_avg of the third diagnosis deviation for each of the plurality of battery cells 110, 120, 130, and 140.

In operation S303, the controller 220 may calculate the fourth diagnosis deviation dV4 of each of the plurality of battery cells 110, 120, 130, and 140, based on Equation 6.

Fourth Diagnosis Deviation (dV4) = Average (dV1_avg) of First Diagnosis Deviation - Average (dV3_avg) of Third Diagnosis Deviation                  [Equation 6]

In operation S303, specifically, the controller 220 may calculate, as the fourth diagnosis deviation dV4 of each of the plurality of battery cells 110, 120, 130, and 140, a deviation between the average dV1_avg of the first diagnosis deviation and the average dV3_avg of the third diagnosis deviation for each of the plurality of battery cells 110, 120, 130, and 140.

In operation S303, the controller 220 may calculate the fourth diagnosis deviation dV4 of each of the plurality of battery cells 110, 120, 130, and 140 by calculating the fourth diagnosis deviation dV4 of each of the plurality of battery cells 110, 120, 130, and 140 for each unit time.

In operation S304, the controller 220 may determine whether the fourth diagnosis deviation of at least any one of the plurality of battery cells 110, 120, 130, and 140 fall out of the third threshold range.

In operation S305, when the fourth diagnosis deviation of at least any one of the plurality of battery cells 110, 120, 130, and 140 falls out of the third threshold range, the controller 220 may diagnose the corresponding battery cell as the under-capacity battery cell. Herein, the third threshold range may be a criterion for determining the battery cell as the under-capacity battery cell. For example, the third threshold range may be from (-)15 mV to (+) 5 mV.

In operation S305, when the controller 220 determines that the under-capacity battery cell occurs in a battery cell, as a result of diagnosis, the controller 220 may provide information about the battery cell to a user. For example, the controller 220 may provide information about the under-capacity battery cell to a user terminal through a communication unit (not shown) and provide the information about the corresponding battery cell through a display provided in a vehicle, a charger, etc.

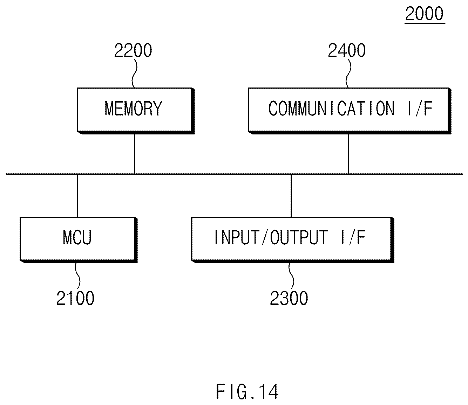

FIG. 14 is a block diagram showing a hardware configuration of a computing system for performing an operating method of a battery management apparatus, according to an embodiment disclosed herein.

Referring to FIG. 14, a computing system 2000 according to an embodiment disclosed herein may include a microcontroller unit (MCU) 2100, a memory 2200, an input/output interface (I/F) 2300, and a communication I/F 2400.

The MCU 2100 may be a processor that executes various programs (e.g., a battery voltage variance analysis program, etc.) stored in the memory 2200, processes various data through these programs, and perform the above-described functions of the battery management apparatus 200 shown in FIG. 1.

The memory 2200 may store various programs regarding operations of the facility control device 200. Moreover, the memory 2200 may store operation data of the battery management apparatus 200.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present disclosure are intended for description rather than limitation of the technical spirit of the present disclosure and the scope of the technical spirit of the present disclosure is not limited by these embodiments. The protection scope of the present disclosure should be interpreted by the following claims, and all technical spirits within the same range should be understood to be included in the range of the present disclosure.

**Claims**

1. A battery management apparatus comprising:

   a data management unit configured to calculate an open circuit voltage (OCV) of each of a plurality of batteries; and
   a controller configured to:

      calculate an average OCV of the plurality of batteries and calculate a diagnosis deviation that is a deviation between the OCV and the average OCV for each of the plurality of batteries;
      classify the diagnosis deviation of each of the plurality of batteries according to a range of the average OCV to generate a diagnosis deviation for each range of the average OCV; and
      diagnose at least one of the plurality of batteries based on the diagnosis deviation for each range of the average OCV of each of the plurality of batteries.

2. The battery management apparatus of claim 1, wherein the controller is further configured to:

   calculate a mean value or a median value of OCVs of the plurality of batteries as the average OCV; and
   classify the diagnosis deviation of each of the plurality of batteries into a first diagnosis deviation, a second diagnosis deviation, and a third diagnosis deviation in a descending order of the range of the average OCV.

3. The battery management apparatus of claim 2, wherein the controller is further configured to diagnose at least one of the plurality of batteries based on whether the first diagnosis deviation and the third diagnosis deviation of each of the plurality of batteries fall within a first threshold range.

4. The battery management apparatus of claim 3, wherein the controller is further configured to, when a first diagnosis deviation and a third diagnosis deviation of the at least one of the plurality of batteries fall out of the first threshold range, diagnose the battery as an under-voltage battery.

5. The battery management apparatus of claim 3, wherein the controller is further configured to, when a first diagnosis deviation and a third diagnosis deviation of the at least one of the plurality of batteries fall within the first threshold range and the first diagnosis deviation and the third diagnosis deviation of the battery fall out of a second threshold range, diagnose the battery based on an accumulative balancing time of the battery.

6. The battery management apparatus of claim 5, wherein the controller is further configured to:

   calculate an accumulative balancing time of each of the plurality of batteries;
   calculate a reference time based on a mean value or a median value of accumulative balancing times of the plurality of batteries; and
   diagnose the battery based on whether the accumulative balancing time of the battery is less than the reference time.

7. The battery management apparatus of claim 6, wherein the controller is further configured to, when the first diagnosis deviation and the third diagnosis deviation of the at least one of the plurality of batteries fall within the first threshold range and out of the second threshold range, and the accumulative balancing time of the battery is less than the reference time, diagnose the battery as the under-voltage battery.

8. The battery management apparatus of claim 2, wherein the controller is further configured to:

   calculate a fourth diagnosis deviation which is a difference between an average of the first diagnosis deviation of each of the plurality of batteries and an average of the third diagnosis deviation; and
   diagnose at least one of the plurality of batteries based on whether the fourth diagnosis deviation of each of the plurality of batteries falls within a third threshold range.

9. The battery management apparatus of claim 8, wherein the controller is further configured to, when the fourth diagnosis deviation of the at least one of the plurality of batteries falls out of the third threshold range, diagnose the battery as an under-capacity battery.

10. An operating method of a battery management apparatus, the operating method comprising:

    calculating an open circuit voltage (OCV) of each of a plurality of batteries;
    calculating an average OCV of the plurality of batteries;
    calculating a diagnosis deviation that is a deviation between the OCV and the average OCV for each of the plurality of batteries;
    classifying the diagnosis deviation of each of the plurality of batteries according to a range of the average OCV to generate a diagnosis deviation for each range of the average OCV; and
    diagnosing at least one of the plurality of batteries based on the diagnosis deviation for each range of the average OCV of each of the plurality of batteries.

11. The operating method of the battery management apparatus of claim 10, wherein the calculating of the average OCV of the plurality of batteries comprises calculating a mean value or a median value of OCVs of the plurality of batteries as the average OCV, and
    the classifying of the diagnosis deviation of each of the plurality of batteries according to a range of the average OCV to generate the diagnosis deviation for each range of the average OCV comprises classifying the diagnosis deviation of each of the plurality of batteries into a first diagnosis deviation, a second diagnosis deviation, and a third diagnosis deviation in a descending order of the range of the average OCV.

12. The operating method of the battery management apparatus of claim 11, wherein the diagnosing of the at least one of the plurality of batteries based on the diagnosis deviation for each range of the average OCV of each of the plurality of batteries comprises diagnosing at least one of the plurality of batteries based on whether the first diagnosis deviation and the third diagnosis deviation of each of the plurality of batteries fall within a first threshold range.

13. The operating method of the battery management apparatus of claim 12, wherein the diagnosing of the at least one of the plurality of batteries based on the diagnosis deviation for each range of the average OCV of each of the plurality of batteries comprises, when a first diagnosis deviation and a third diagnosis deviation of the at least one of the plurality of batteries fall out of the first threshold range, diagnosing the battery as an under-voltage battery.

14. The operating method of the battery management apparatus of claim 12, wherein the diagnosing of the at least one of the plurality of batteries based on the diagnosis deviation for each range of the average OCV of each of the plurality of batteries comprises, when a first diagnosis deviation and a third diagnosis deviation of the at least one of the plurality of batteries fall within the first threshold range and the first diagnosis deviation and the third diagnosis deviation of the battery fall out of a second threshold range, diagnosing the battery based on an accumulative balancing time of the battery.

15. The operating method of the battery management apparatus of claim 14, wherein the diagnosing of the at least one of the plurality of batteries based on the diagnosis deviation for each range of the average OCV of each of the plurality of batteries comprises:

    calculating an accumulative balancing time of each of the plurality of batteries;
    calculating a reference time based on a mean value or a median value of accumulative balancing times of the plurality of batteries; and
    diagnosing the battery based on whether the accumulative balancing time of the battery is less than the reference time.

16. The operating method of the battery management apparatus of claim 15, wherein the diagnosing of the at least one of the plurality of batteries based on the diagnosis deviation for each range of the average OCV of each of the plurality of batteries comprises, when the first diagnosis deviation and the third diagnosis deviation of the at least one of the plurality of batteries fall within the first threshold range and out of the second threshold range, and the accumulative balancing time of the battery is less than the reference time, diagnosing the battery as the under-voltage battery.

17. The operating method of the battery management apparatus of claim 11, wherein the diagnosing of the at least one of the plurality of batteries based on the diagnosis deviation for each range of the average OCV of each of the plurality of batteries comprises:

    calculating a fourth diagnosis deviation which is a difference between an average of the first diagnosis deviation of each of the plurality of batteries and an average of the third diagnosis deviation; and
    diagnosing at least one of the plurality of batteries based on whether the fourth diagnosis deviation of each of the plurality of batteries falls within a third threshold range.

18. The operating method of the battery management apparatus of claim 17, wherein the diagnosing of the at least one of the plurality of batteries based on the diagnosis deviation for each range of the average OCV of each of the plurality of batteries comprises, when the fourth diagnosis deviation of the at least one of the plurality of batteries falls out of the third threshold range, diagnosing the battery as an under-capacity battery.

1000

300

100

110

120

130

140

BATTERY
MANAGEMENT
APPARATUS
200

FIG.1

200

| | | | |
|---|---|---|---|
| DATA MANAGEMENT UNIT<br>210 | | CONTROLLER<br>220 | |

FIG.2

FIG.3

FIG.4

FIG.5

EP 4 692 825 A1

Voltage [mV]

SECOND
THRESHOLD
RANGE

FIRST
THRESHOLD
RANGE

Time [S]

FIG.6A

Voltage [mV]

SECOND
THRESHOLD
RANGE

FIRST
THRESHOLD
RANGE

Time [S]

FIG.6B

FIG.7

Voltage [mV]

FIRST
THRESHOLD
RANGE

Time [S]

FIG.8A

Voltage [mV]

FIRST
THRESHOLD
RANGE

Time [S]

FIG.8B

Voltage [mV]                                          SOC[%]

FIG.9A

Time[Day]

Voltage [mV]                                          SOC[%]

FIG.9B

Time[Day]

FIG.10

```
                        ┌─────────────┐
                        │    START    │
                        └──────┬──────┘
                               │
                               ▼
┌──────────────────────────────────────────────────────┐
│  CALCULATE OCV OF EACH OF PLURALITY OF BATTERIES       │───S101
└──────────────────────────┬───────────────────────────┘
                           │
                           ▼
┌──────────────────────────────────────────────────────┐
│  CALCULATE AVERAGE OCV OF PLURALITY OF BATTERIES       │───S102
└──────────────────────────┬───────────────────────────┘
                           │
                           ▼
┌──────────────────────────────────────────────────────┐
│         CALCULATE DIAGNOSIS DEVIATION THAT IS          │
│              DEVIATION BETWEEN OCV OF                   │───S103
│    EACH OF PLURALITY OF BATTERIES AND AVERAGE OCV       │
└──────────────────────────┬───────────────────────────┘
                           │
                           ▼
┌──────────────────────────────────────────────────────┐
│      CLASSIFY DIAGNOSIS DEVIATION OF EACH OF           │
│   PLURALITY OF BATTERIES ACCORDING TO RANGE OF         │
│  AVERAGE OCV TO GENERATE DIAGNOSIS DEVIATION FOR       │───S104
│         EACH RANGE OF AVERAGE OCV                       │
└──────────────────────────┬───────────────────────────┘
                           │
                           ▼
┌──────────────────────────────────────────────────────┐
│        DIAGNOSE AT LEAST ONE OF PLURALITY OF           │
│   BATTERIES BASED ON DIAGNOSIS DEVIATION FOR           │
│          EACH RANGE OF AVERAGE OCV OF                   │───S105
│         EACH OF PLURALITY OF BATTERIES                 │
└──────────────────────────┬───────────────────────────┘
                           │
                           ▼
                        ┌─────────────┐
                        │     END     │
                        └─────────────┘
```

FIG.11

START

CALCULATE TIME-SERIES DATA OF
FIRST DIAGNOSIS DEVIATION AND
THIRD DIAGNOSIS DEVIATION OF EACH OF
PLURALITY OF BATTERY CELLS ——S201

DO FIRST
DIAGNOSIS DEVIATION AND
THIRD DIAGNOSIS DEVIATION
FALL WITHIN FIRST
THRESHOLD RANGE? — S202
NO

YES

DO FIRST
DIAGNOSIS DEVIATION AND
THIRD DIAGNOSIS DEVIATION FALL
WITHIN SECOND THRESHOLD
RANGE? — S203
NO

YES

CALCULATE ACCUMULATIVE BALANCING TIME OF
EACH OF PLURALITY OF BATTERY CELLS ——S204

ACCUMULATIVE BALANCING TIME
< REFERENCE TIME? — S205

YES

DIAGNOSE UNDER-VOLTAGE BATTERY CELL ——S206

END

FIG.12

FIG.13

2000

2200                          2400

| MEMORY | | COMMUNICATION I/F |

| MCU | | INPUT/OUTPUT I/F |

2100                          2300

FIG.14

## INTERNATIONAL SEARCH REPORT

| International application No. |
| --- |
| **PCT/KR2024/005995** |

| | |
| --- | --- |
| **A.** | **CLASSIFICATION OF SUBJECT MATTER** |
| | **G01R 31/396**(2019.01)i; **G01R 31/08**(2006.01)i; **G01R 19/10**(2006.01)i; **G01R 19/30**(2006.01)i; **H02J 7/00**(2006.01)i; **B60R 16/033**(2006.01)i; **B60L 58/10**(2019.01)i |
| | According to International Patent Classification (IPC) or to both national classification and IPC |

| | |
| --- | --- |
| **B.** | **FIELDS SEARCHED** |
| | Minimum documentation searched (classification system followed by classification symbols) |
| | G01R 31/396(2019.01); B60L 50/50(2019.01); G01R 31/36(2006.01); G01R 31/388(2019.01); H01M 10/04(2006.01); H02J 7/14(2006.01) |
| | Documentation searched other than minimum documentation to the extent that such documents are included in the fields searched |
| | Korean utility models and applications for utility models: IPC as above<br>Japanese utility models and applications for utility models: IPC as above |
| | Electronic data base consulted during the international search (name of data base and, where practicable, search terms used) |
| | eKOMPASS (KIPO internal) & keywords: 배터리(battery), 개방 회로 전압(open circuit voltage), 평균(average), 편차 (deviation), 컨트롤러(controller) |

| | |
| --- | --- |
| **C.** | **DOCUMENTS CONSIDERED TO BE RELEVANT** |

| Category* | Citation of document, with indication, where appropriate, of the relevant passages | Relevant to claim No. |
| --- | --- | --- |
| A | KR 10-2010-0019256 A (LG CHEM, LTD.) 18 February 2010 (2010-02-18)<br>See paragraphs [0084]-[0088] and figure 1. | 1-18 |
| A | KR 10-2012-0068919 A (TOYOTA JIDOSHA KABUSHIKI KAISHA) 27 June 2012 (2012-06-27)<br>See paragraphs [0055]-[0058] and figure 7. | 1-18 |
| A | KR 10-2003-0092393 A (HYUNDAI MOTOR COMPANY) 06 December 2003 (2003-12-06)<br>See claims 1-6 and figure 2. | 1-18 |
| A | KR 10-2019-0089421 A (LG INNOTEK CO., LTD.) 31 July 2019 (2019-07-31)<br>See paragraphs [0043]-[0045] and figure 5. | 1-18 |
| A | US 2022-0276310 A1 (CONTEMPORARY AMPEREX TECHNOLOGY CO., LIMITED) 01 September 2022 (2022-09-01)<br>See paragraphs [0025]-[0071] and figure 1. | 1-18 |

| | |
| --- | --- |
| ☐ Further documents are listed in the continuation of Box C. | ☑ See patent family annex. |

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **06 August 2024** | **07 August 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/005995**

| Patent document cited in search report | | | Publication date (day/month/year) | Patent family member(s) | | | Publication date (day/month/year) |
|---|---|---|---|---|---|---|---|
| KR | 10-2010-0019256 | A | 18 February 2010 | CN | 102203626 | A | 28 September 2011 |
| | | | | CN | 102203626 | B | 20 August 2014 |
| | | | | EP | 2320242 | A2 | 11 May 2011 |
| | | | | EP | 2320242 | A4 | 13 November 2013 |
| | | | | EP | 2320242 | B1 | 13 January 2016 |
| | | | | JP | 2011-530697 | A | 22 December 2011 |
| | | | | JP | 5605717 | B2 | 15 October 2014 |
| | | | | KR | 10-1187766 | B1 | 05 October 2012 |
| | | | | KR | 10-1402802 | B1 | 03 June 2014 |
| | | | | US | 2010-0085009 | A1 | 08 April 2010 |
| | | | | US | 9287723 | B2 | 15 March 2016 |
| | | | | WO | 2010-016661 | A2 | 11 February 2010 |
| | | | | WO | 2010-016661 | A3 | 22 April 2010 |
| KR | 10-2012-0068919 | A | 27 June 2012 | CN | 102576895 | A | 11 July 2012 |
| | | | | CN | 102576895 | B | 27 August 2014 |
| | | | | JP | 5541288 | B2 | 09 July 2014 |
| | | | | JP | WO2011-036705 | A1 | 14 February 2013 |
| | | | | US | 2012-0176140 | A1 | 12 July 2012 |
| | | | | US | 9157964 | B2 | 13 October 2015 |
| | | | | WO | 2011-036705 | A1 | 31 March 2011 |
| KR | 10-2003-0092393 | A | 06 December 2003 | KR | 10-0460876 | B1 | 09 December 2004 |
| KR | 10-2019-0089421 | A | 31 July 2019 | KR | 10-2618739 | B1 | 29 December 2023 |
| US | 2022-0276310 | A1 | 01 September 2022 | CN | 114002603 | A | 01 February 2022 |
| | | | | CN | 114002603 | B | 02 August 2022 |
| | | | | EP | 4024068 | A1 | 06 July 2022 |
| | | | | EP | 4024068 | A4 | 21 December 2022 |
| | | | | EP | 4024068 | B1 | 07 June 2023 |
| | | | | ES | 2951968 | T3 | 26 October 2023 |
| | | | | HU | E062597 | T2 | 28 November 2023 |
| | | | | US | 11598811 | B2 | 07 March 2023 |
| | | | | WO | 2022-012139 | A1 | 20 January 2022 |

Form PCT/ISA/210 (patent family annex) (July 2022)

**EP 4 692 825 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230061140